(19) Europäisches Patentamt
European Patent Office
Office européen des brevets

(11) **EP 2 192 687 B1**

(12) **EUROPÄISCHE PATENTSCHRIFT**

(45) Veröffentlichungstag und Bekanntmachung des Hinweises auf die Patenterteilung:
**19.03.2014 Patentblatt 2014/12**

(51) Int Cl.:
***H03F 1/42*** *(2006.01)*

(21) Anmeldenummer: **09014521.0**

(22) Anmeldetag: **20.11.2009**

(54) **Verstärker und Verstärkerschaltung mit geschalteter Kapazität**

Amplifier and amplifier switch with switched capacity

Amplificateur et commutation d'amplification dotée d'une capacité commutée

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **01.12.2008 DE 102008059734**

(43) Veröffentlichungstag der Anmeldung:
**02.06.2010 Patentblatt 2010/22**

(73) Patentinhaber: **Entropic Communications, Inc.
San Diego, CA 92121 (US)**

(72) Erfinder:
• **Garcia Gonzáles, Josè Manuel
79211 Denzlingen (DE)**
• **Greitschus, Norbert
79346 Endingen (DE)**

(74) Vertreter: **Epping - Hermann - Fischer Patentanwaltsgesellschaft mbH
Schloßschmidstraße 5
80639 München (DE)**

(56) Entgegenhaltungen:
| | |
|---|---|
| EP-A- 0 777 319 | WO-A-02/01711 |
| WO-A-94/22216 | GB-A- 2 167 195 |
| JP-A- 59 224 906 | JP-A- 60 128 702 |
| US-A- 3 153 202 | US-A- 4 543 534 |
| US-A- 6 037 836 | US-A1- 2002 024 363 |
| US-A1- 2002 027 453 | US-A1- 2002 153 946 |
| US-A1- 2004 085 135 | US-A1- 2006 091 955 |

EP 2 192 687 B1

**Beschreibung**

Die Erfindung bezieht sich auf einen Verstärker für eine Verstärkerschaltung mit geschalteter Kapazität mit den oberbegrifflichen Merkmalen gemäß Patentanspruch 1 bzw. auf eine solche Verstärkerschaltung mit geschalteter Kapazität und einem solchen Verstärker.

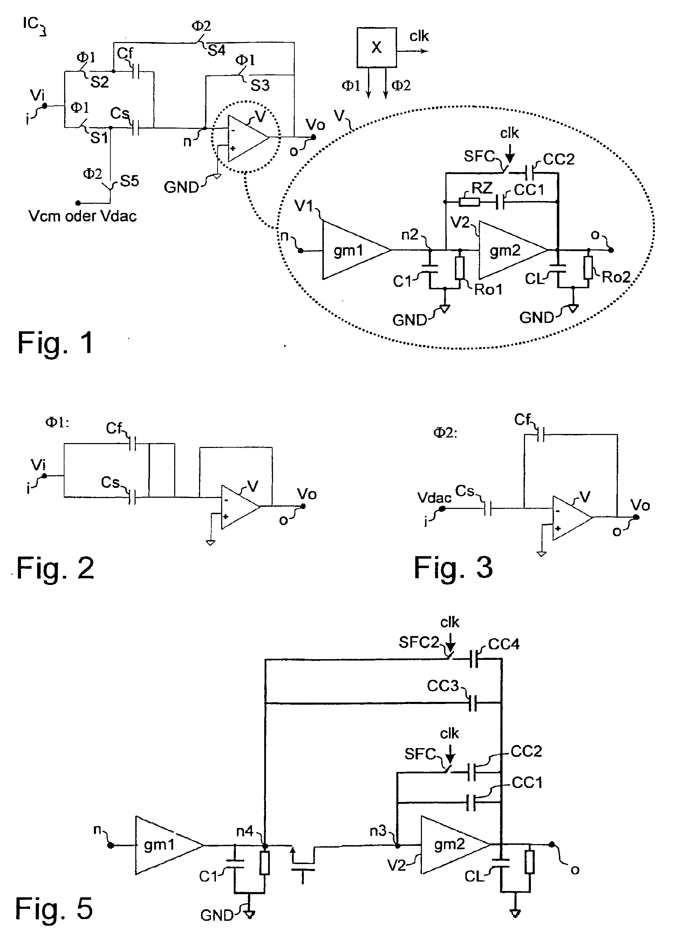

Schaltungen mit geschalteter Kapazität (engl. switched capacitor circuits) werden in zahlreichen Applikationen als Verstärker verwendet. Ein Beispiel ist eine Verwendung in einem sogenannten Pipeline-Analog-Digital-Wandler. Fig. 1 zeigt im linken, nicht vergrößert dargestellten Figurenabschnitt eine besondere Form einer Verstärkeranordnung mit einer Verstärkerschaltung IC. Die Verstärkeranordnung ist mit geschalteten Kapazität Cf, Csausgebildet und wird nachfolgend auch als Switched Capacitor Verstärker bezeichnet. Hierbei eine beispielhafte Anwendung in Reset-Konfiguration (engl. reset / deutsch: rücksetz) dargestellt. Mit dieser Konfiguration lassen sich Probleme durch einen Offset (deutsch: Versatz) eines darin eingesetzten Verstärkers V umgehen, da dieser Offset in einer ersten Taktphase Φ1 von zwei Taktphasen Φ1, Φ2 (engl. Clockphases) gespeichert wird und in einer zweiten der Taktphasen Φ2 nicht mehr als Fehler in Erscheinung tritt.

Ein Schaltungseingang i, an welchem eine Eingangsspannung Vi anliegt, führt zu einem ersten Schalter S1 und einem parallel dazu geschalteten zweiten Schalter S2. Ansteuerbar zum Schließen sind diese beiden Schalter S1, S2 durch ein erstes Schaltsignal, welches in einer ersten Taktphase Φ1 angelegt wird. Zwischen den ersten Schalter S1 und einen Verstärker-Eingangsknoten n des Verstärkers V* ist in Reihe eine zweite schaltbare Kapazität Cs geschaltet. Außerdem ist zwischen den zweiten Schalter S2 und den Verstärker-Eingangsknoten n eine erste schaltbare Kapazität Cf geschaltet. Ein negativ gesetzter Eingang des Verstärkers V* ist zwischen den Verstärker-Eingangsknoten n und einen Schaltungsausgang bzw. Verstärker-Ausgangsknoten o geschaltet. An dem Verstärker-Ausgangsknoten o ergibt sich eine Ausgangsspannung Vo. Ein positiv gesetzter Eingang des Verstärkers V ist an einen Masseanschluss bzw. an ein Bezugspotential GND geschaltet.

Außerdem ist der Verstärker-Eingangsknoten n über einen dritten Schalter S3 parallel zum Verstärker V an den Verstärker-Ausgangsknoten o schaltbar. Zum schließenden Schalten des dritten Schalters S3 ist an diesen ebenfalls das erste Schaltsignal Φ 1 anlegbar. Außerdem ist an einen Knoten zwischen dem ersten Schalter S1 und der zweiten schaltbaren Kapazität Cs über einen fünften Schalter S5 eine Steuerspannung in Form beispielsweise einer Digital-/Analog-Wandler-Ausgangsspannung Vdac oder ein weiteres Bezugspotential, wie eine Referenzspannung Vcm, anlegbar. Zum schließenden Schalten des fünften Schalters S5 dient ein zweites Schaltsignal, welches in der zweiten Taktphase Φ2 angelegt wird. Über einen vierten Schalter S4, welcher ebenfalls mittels des zweiten Schaltsignals schließend angesteuert wird, ist ein Knoten zwischen dem zweiten Schalter S2 und der ersten schaltbaren Kapazität Cf mit dem Verstärker-Ausgangsknoten o zusammenschaltbar.

Außerdem weist die Anordnung eine Steuereinrichtung X auf, welche unter anderem zum Bereitstellen des ersten und des zweiten Schaltsignals in der ersten bzw. zweiten Taktphase Φ1, Φ2 ausgebildet ist. Die Ansteuerung erfolgt dabei in für sich bekannter Art und Weise.

Während der ersten Taktphase Φ1 sind, wie anhand Fig. 2 skizziert, die Kondensatoren bzw. deren Kapazitäten CS und CF parallel geschaltet und mittels der ersten beiden in Fig. 1 skizzierten Schalter S1 und S2 an den Schaltungseingang i angeschlossen. Der Verstärker V ist mittels des dritten Schalters S3 vollständig rückgekoppelt. Die Ausgangsspannung Vo und damit die Spannung am zweiten Knoten der beiden Kapazitäten Cs & Cf ist die Referenzspannung Vcm, welche auch als Common Mode Spannung bezeichnet wird, plus die Offsetspannung Voff des Verstärkers V. Auf der Parallelschaltung der ersten beiden Kapazitäten $C_S$ & $C_F$ wird somit die Differenz der Eingangsspannung Vi und der Summe der Offsetspannung Voff und der Referenzspannung Vcm gespeichert.

Während der zweiten Taktphase $\Phi_2$ sind, wie anhand Fig. 3 skizziert, die ersten beiden ersten in Fig. 1 skizzierten Schalter S1 und S2 geöffnet. Der fünfte Schalter S5 ist geschlossen und verbindet die zweite schaltbare Kapazität Cs mit der Referenzspannung Vcm bei einem Switched Capacitor Verstärker bzw. mit einer Digital/Analog-Wandler-Ausgangsspannung Vdac bei einem Pipeline-Analog-Digital-Wandler. Gleichzeitig ist die vollständige Rückkopplung des Verstärkers V aufgehoben, da der dritte Schalter S3 geöffnet ist, und die erste schaltbare Kapazität Cf ist mittels des geschlossenen vierten Schalters S4 vom Verstärker-Eingangsknoten n des Verstärkers V auf dessen Ausgangsknoten o geschaltet. Damit ergibt sich als Ausgangsspannung des Verstärkers V in der zweiten Taktphase $\Phi_2$ der Wert

$$Vo(\Phi1) = Vi - (Vcm + Voff)$$

und

$$Vo(\Phi2) = \frac{Cs + Cf}{Cf} \cdot Vi(\Phi1) = Gain \cdot Vi(\Phi1) \ .$$

Die Ausgangsspannung Vo in der zweiten Taktphase $\Phi_2$ ist damit die um die verstärkte, negative Eingangsspannung Vi in der ersten Taktphase $\Phi_1$, die Offsetspannung Voff kompensiert. Die Verstärkung Gain = 1+(Cs/Cf) der Gesamtanordnung ist

$$Gain = \frac{Cf + Cs}{Cf} = 1 + \frac{Cs}{Cf} \ .$$

Bekanntermaßen ist diese Gleichung nur exakt, wenn eine Verstärkung A0 des Verstärkers V einen unendlich großen Wert besitzt. Bei endlichem Wert der Verstärkung A0 ist die Ausgangsspannung um den Wert eines Verstärkungsfehlers Aerr falsch.

$$Gain, real = \frac{Cf + Cs}{Cf} \cdot \frac{1}{1 + 1/A0} = \frac{Cf + Cs}{Cf} \cdot Aerr \ .$$

Der Verstärkungsfehler Aerr wird um so geringer, je größer die Verstärkung A0 des Verstärkers V ist.

Um den Fehler der Verstärkung V0 so klein wie möglich zu halten, werden z.B. in dem Verstärker V einstufige Verstärkeranordnungen, so genannte OTA-Schaltungen, d.h. Transkonduktanzverstärker bzw. ein Operationsverstärker mit stromgesteuerter Verstärkung, in Verbindung mit Kaskodenschaltungen verwendet. Die Verstärkung V0 kann hierbei weiter erhöht werden durch Verwendung von so genannten Gain Boosting Schaltungen. Der Vorteil der einstufigen Anordnungen ist, dass hohe Bandbreiten erreicht werden, da zusätzliche Maßnahmen zur Frequenzkompensation nicht erforderlich sind.

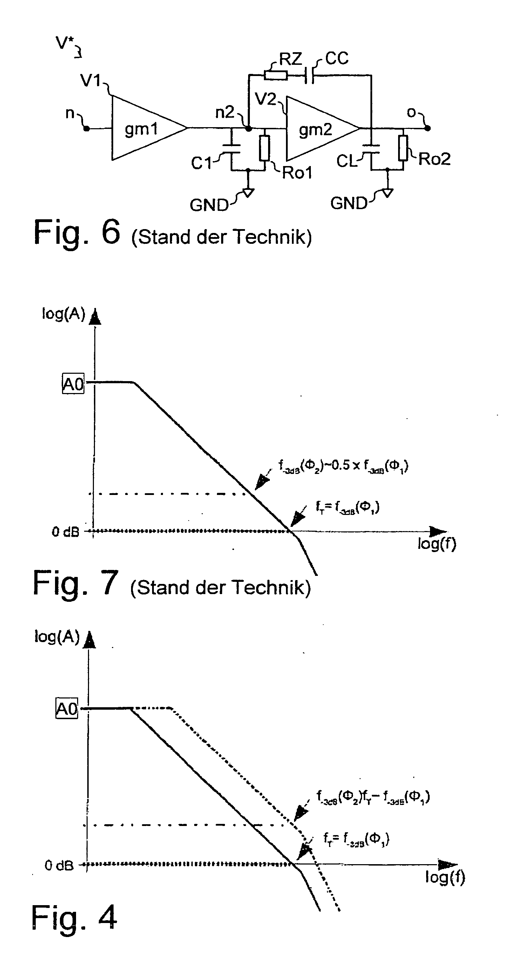

Bei Anwendungen mit kleinen Versorgungsspannungen ist die Verwendung von Kaskodenschaltungen jedoch kaum noch möglich. Hier finden mehrstufige Verstärkeranordnungen Anwendung um eine möglichst hohe Verstärkung A0 zu erzielen. Die Reduktion der Verstärkung A0 durch fehlende Kaskodenanordnungen wird durch weitere, kaskadierte Verstärkerstufen kompensiert. Nachteilig ist hierbei, dass zusätzliche Maßnahmen zur Frequenzkompensation erfolgen müssen, um regelungstechnisch stabile Systeme zu garantieren. Fig. 6 zeigt eine mögliche zweistufige Verstärkungsanordung eines Verstärkers V* mit Frequenzkompensation.

In Reihe geschaltet sind zwischen den Verstärker-Eingangsknoten n und den Verstärker-Ausgangsknoten o eine vorgeschaltete Verstärkerstufe V1 und eine Verstärkerstufe V2, welche eine Steilheit gm1 bzw. gm2 aufweisen. Zwischen den beiden Verstärkerstufen V1, V2 befindet sich ein Knoten, welcher nachfolgend als Kompensations-Eingangsknoten n2 bezeichnet wird. Zwischen Masseanschluss bzw. das Bezugspotential GND und den Kompensations-Eingangsknoten n2 sind parallel zueinander eine erste Verstärker-Kapazität C1 und ein erster weiterer Widerstand Ro1 geschaltet. Außerdem ist zwischen das Masse- bzw. Bezugspotential GND und den Verstärker-Ausgangsknoten o eine Lastkapazität CL und ein zweiter weiterer Widerstand Ro2 parallel zueinander geschaltet.

In einer praktischen Umsetzung kann insbesondere die erste Verstärker-Kapazität C1 und der erste weitere Widerstand Ro1 bereits durch Bauelemente-Eigenschaften gebildet sein. Der erste weitere Widerstand Ro1 ist dabei der Ausgangswiderstand der vorgeschalteten Verstärkerstufe V1 als Quelle der realen Steilheit gm1, die erste Verstärker-Kapazität C1 ist die Eingangskapazität der zweiten Verstärkerstufe V2 mit deren Steilheit gm2 und die parasitäre Lastkapazität des Ausgangs der vorgeschalteten Verstärkerstufe V1. Eine explizite Plazierung eines ersten weiteren Widerstands Ro1 oder der ersten Verstärker-Kapazität C1 muss nicht, kann aber stattfinden. Entsprechend reichen ggfs. die vorhandenen parasitären Elemente aus.

Parallel zu der zweiten der Verstärkerstufen V2 ist zwischen den Kompensations-Eingangsknoten n2 und den Verstärker-Ausgangsknoten o in Reihe ein erster Kompensationswiderstand RZ und eine Kapazität bzw. Gesamtkapazität zur Frequenzkompensation CC geschaltet.

Das Problem bei der anhand Fig. 1 linksseitig skizzierten Switched Capacitor Verstärkeranordnung in Verbindung mit dem Verstärker V* gemäß Fig. 6 ist, dass ein Rückkopplungsfaktor $\beta$ des Verstärkers V* in den beiden Takt-phasen $\Phi_1$ und $\Phi_2$ unterschiedlich ist:

$$\beta(\Phi 1) \neq \beta(\Phi 2).$$

Während der ersten Taktphase $\Phi_1$ ist der Verstärker V* vollständig rückgekoppelt. Der Rückkopplungsfaktor $\beta(\Phi_1)$ ist dann

$$\beta(\Phi 1) = 1.$$

Während der zweiten Taktphase $\Phi_2$ ist der Verstärker V* jedoch nur zu einen kleineren Teil rückgekoppelt. Der Rückkopplungsfaktor $\beta(\Phi_2)$ ist dann kleiner als 1 und beträgt

$$\beta(\Phi 2) = \frac{Cf}{Cf + Cs} = \frac{1}{1 + Cs/Cf}.$$

Für einen klassischen 1.5-Bit Pipeline-Analog-Digital-Wandler ist Cf = Cs und damit der Rückkopplungsfaktor $\beta(\Phi 2)$ während der zweiten Taktphase $\Phi 2$ gleich 1/2.

Eine Frequenzkompensation für mehrstufige Verstärker ist so auszulegen, dass in beiden Taktphasen $\Phi 1$, $\Phi 2$ ein regelungstechnisch stabiles System besteht. Durch den größeren Rückkopplungsfaktor $\beta(\Phi 1)$ während der ersten Taktphase $\Phi 1$ ist diese Phase die entscheidende Phase für die Frequenzkompensation.

Fig. 6 veranschaulicht eine mögliche Frequenzkompensation für ein Verstärkungssystem 2. Ordnung, eine so genannte Miller-Kompensation. Für einen Rückkopplungsfaktor $\beta$ von $\beta = 1$ und bei gegebener Lastkapazität CL ergibt sich bei gewählten Steilheiten $g_{m1}$ und $g_{m2}$ der beiden Verstärkerstufen V1, V2 eine bestimmte Transitfrequenz $f_T$, wie dies aus z.B. P.E. Allan, D.R. Holberg; CMOS Analog Circuit Design; Oxford University Press; 1987; ISBN 0-19-510720-9; page 374ff; Abschnitt 8.2 etc. bekannt ist. Diese Transitfrequenz $f_T$ ist gleich einem Verstärkungs-Bandbreiten-Produkt GBW des Verstärkers V* und bei dem Rückkopplungsfaktor $\beta$ von $\beta = 1$ gleich der -3dB-Bandbreite des rückgekoppelten Verstärkers V* mit $f_T = f_{-3dB\ Gain}(\Phi 1)$ des Operationsverstärkers OPV:

$$GBW = A0 \cdot f_{-3dB\ OPV}$$

$$\text{für } \beta = 1 \rightarrow GBW = fT = g_{m1}/2\pi C_C$$

$$\rightarrow f_{-3dB\ Gain}(\Phi 1) = f_T \cdot \beta(\Phi 1) = g_{m1}/2\pi C_C.$$

Während der zweiten Taktphase $\Phi_2$ ist der Rückkopplungsfaktor $\beta$ u.U. wesentlich geringer. Bei einer Pipeline-Analog-Digital-Wandler-Stufe mit einer Verstärkung A0 von Gain = 2 ist der Rückkopplungsfaktor $\beta$ nur 1/2. Da das Verstärkungs-Bandbreiten-Produkt GBW jedoch konstant ist und für die erste Taktphase $\Phi_1$ ausgelegt werden muss, ist die resultierende -3dB-Bandbreite des rückgekoppelten Verstärkers V* mit $f_T = f_{-3dB\ Gain}(\Phi 2)$:

$$GBW = A0 \cdot f_{-3dB\ OPV}$$

$$\text{für } \beta = 1 \rightarrow GBW = fT = g_{m1}/2\pi C_C$$

$$\rightarrow f_{-3dB\ Gain}(\Phi 2) = fT \cdot \beta(\Phi 2) = g_{m1}/(2 \times 2\pi C_C) = \frac{1}{2} \cdot f_{-3dB\ Gain}(\Phi 1).$$

Die Bandbreite des rückgekoppelten Verstärkers V* während der zweiten Taktphase Φ2 ist damit nur halb so groß wie während der ersten Taktphase Φ1. Das führt zu einer längeren Einschwingzeit, was nur durch eine höhere Bandbreite in der ersten Taktphase Φ1 und damit durch eine höhere Stromaufnahme zu umgehen ist.

Fig. 7 zeigt anschaulich einen Frequenzgang der Leerlaufverstärkung (engl. Open Loop) sowie den daraus resultierenden Frequenzgang der rückgekoppelten Schaltung, für ß = 1 während der ersten Taktphase Φ1, sowie für β = 1/2 während der zweiten Taktphase Φ2.

In dem Dokument US 2002/153946 A1 ist ein Switched capacitor Verstärker angegeben.

Die Aufgabe der Erfindung besteht darin, einen Verstärker bzw. eine Verstärkerschaltung mit geschalteter Kapazität mit verbessertem Schaltungsaufbau bereitzustellen. Insbesondere soll ein Nachteil einer Bandbreitenreduktion des Systems während der zweiten Taktphase umgangen werden ohne die Leistungsaufnahme zu erhöhen.

Diese Aufgabe wird durch den Verstärker mit den Merkmalen des Patentanspruchs 1 und dem Verfahren nach Patentanspruch 3 gelöst. Vorteilhafte Ausgestaltungen sind Ge-genstand von abhängigen Ansprüchen.

Dies wird ermöglicht durch einen Verstärker für eine Verstärkerschaltung mit geschalteter Kapazität, wobei zu einer Verstärkerstufe parallel eine Kapazität zur Frequenzkompensation geschaltet ist und wobei zumindest eine zweite Kapazität zur Frequenzkompensation mittels eines Kapazitäts-Schaltsignals und/oder eines Kompensationschalters zu- oder wegschaltbar parallel zu dieser ersten Kapazität zur Frequenzkompensation geschaltet ist.

Demgemäß wird der Verstärker so aufgebaut, dass das Verstärkungs-Bandbreiten-Produkt während der beiden Taktphasen nicht mehr gleich ist bzw. GBW (Φ1) ≠ GBW (Φ2) gilt. Im Rahmen der Beschreibung wird unter einem Widerstand vorzugsweise ein Ohmscher Widerstand verstanden. Unter einer Kapazität wird eine Komponente verstanden, welche eine kapazitive Wirkung hat, insbesondere also ein Kondensator. Unter zu- oder wegschaltbar wird verstanden, dass ein Schalter ein- oder ausgeschaltet wird. Unter einem Schalter kann jegliche Form eines Schalters verstanden werden, insbesondere Transistoren oder sonstige Halbleiterstrukturen mit einer entsprechenden Schaltfunktion.

Der Kompensationsschalter weist bevorzugt einen Schalterwiderstand größer Null auf, welcher zugeschaltet eine Reihenschaltung eines insbesondere Ohm'schen Widerstands zu der zweiten Kapazität zur Frequenzkompensation bewirkt. Dadurch kann der Schalterwiderstand des Schalters ausgenutzt werden, um gleichzeitig eine weitere Verbesserung der Frequenzkompensation zu erreichen.

Der Schalterwiderstand entspricht insbesondere einem so genannten Nulling-Resistor oder eines Teiles davon. Es kann beispielsweise auch eine Kombination für den Nulling-Resistor benutzt werden, die aus dem sogenannten ein-Widerstand des Schalters und eines weiteren, explizit platzierten Widerstand besteht.

Bevorzugt ist ein Kompensationswiderstand in Reihe mit der nicht geschalteten ersten Kapazität zur Frequenzkompensation geschaltet.

Insbesondere kann der Kompensationswiderstand durch einen Schalter ausgebildet sein. Besonders bevorzugt ist der Kompensationswiderstand durch weiteren und geschlossenen Schalter mit Parametern des Kompensationsschalters ausgebildet, wobei der weitere Kompensationsschalter nicht geschaltet wird oder nicht schaltbar ist. Ein solcher Dummy-Schalter in Serie mit einer nicht geschalteten ersten Kapazität zur Frequenzkompensation ist als "Nulling-Resistor" vorteilhaft, um eine Verbesserung des Matching mit der anderen, geschalteten zweiten Kapazität zur Frequenzkompensation zu erreichen.

Auch demgegenüber erweiterte Verstärker sind umsetzbar. So kann die erste Kapazität zur Frequenzkompensation und die zumindest eine zweite Kapazität oder der zur Frequenzkompensation oder der Kompensationsschalter an einen Eingang der Verstärkerstufe geschaltet sein und an einen Ausgang einer dazu vorgeschalteten Verstärkerstufe und zu der Verstärkerstufe parallel eine dritte Kapazität zur Frequenzkompensation geschaltet sein, wobei dann eine vierte Kapazität zur Frequenzkompensation mittels eines weiteren Kapazitäts-Schaltsignals und/oder eines weiteren Kompensationsschalters zu- oder wegschaltbar parallel zu dieser dritten Kapazität zur Frequenzkompensation geschaltet ist. Außerdem wird dann bevorzugt eine Vorspannung geschaltet zwischen einerseits den Eingang der Verstärkerstufe, den Anschluss der ersten Kapazität zur Frequenzkompensation daran und den Anschluss der zumindest zweiten Kapazität oder des Kompensationsschalters daran und zwischen andererseits den Ausgang der vorgeschalteten Verstärkerstufe, den Anschluss der dritten Kapazität zur Frequenzkompensation daran und den Anschluss der vierten Kapazität zur Frequenzkompensation oder des weiteren Kompensationsschalters daran.

Eigenständig vorteilhaft ist eine Verstärkerschaltung mit geschalteter Kapazität, welche zumindest einen solchen Verstärker aufweist.

Bevorzugt wird eine Verstärkerschaltung, bei welcher in einer ersten Taktphase eine erste solche schaltbare Kapazität und eine zweite solche schaltbare Kapazität parallel zueinander vor einen Verstärker-Eingangsknoten des Verstärkers schaltbar ist und in einer zweiten Taktphase die erste schaltbare Kapazität und die zweite schaltbare Kapazität in Reihe schaltbar sind, wobei in der zweiten Taktphase die erste schaltbare Kapazität parallel zu dem Verstärker zwischen den Verstärker-Eingangsknoten und einen Verstärker-Ausgangsknoten geschaltet ist. Vorteilhaft ermöglicht wird dadurch eine schaltbare Frequenzkompensationskapazität in Switch Capacitor-Verstärkern in Reset-Konfiguration zur unabhängigen Optimierung des Einschwingverhaltens in den beiden verschiedenen Taktphasen durch Zuschalten zusätzlicher Kapazitäten während der einen, insbesondere ersten Taktphase mit einem Schalter.

Der Kompensationsschalter ist bevorzugt während der ersten Taktphase geschlossen und die erste Kapazität zur Frequenzkompensation parallel zur zweiten Kapazität zur Frequenzkompensation schaltet. Der Kompensationsschalter ist entsprechend während der zweiten Taktphase geöffnet und die erste Kapazität zur Frequenzkompensation ist wegschaltet.

Mehrere geteilte und geschaltete solcher Kapazitäten zur Frequenzkompensation als Kompensationskapazitäten können auch in einer so genannten verteilten Kompensation (engl. nested compensation) eingesetzt sein..

Eigenständig bevorzugt wird außerdem ein Verfahren zum Steuern eines solchen Verstärkers und/oder einer solchen Verstärkerschaltung, wobei ein Kapazitäts-Schaltsignal angelegt wird, mit dem die zumindest eine zweite Kapazität zur Frequenzkompensation parallel zu der ersten Kapazität zur Frequenzkompensation zu- oder weggeschaltet wird.

Der Kompensationsschalters wird dabei bevorzugt während der ersten Taktphase geschlossen und die erste Kapazität zur Frequenzkompensation parallel zur zweiten Kapazität zur Frequenzkompensation geschaltet wird. Entsprechend wird der Kompensationsschalter während der zweiten Taktphase geöffnet und die erste Kapazität zur Frequenzkompensation weggeschaltet.

Vorteilhaft ermöglicht wird eine schaltbare Frequenzkompensationskapazität in Switch Capacitor-Verstärkern in Reset-Konfiguration zur unabhängigen Optimierung des Einschwingverhaltens in den beiden verschiedenen Taktphasen durch Zuschalten zusätzlicher Kapazitäten während der einen, insbesondere ersten Taktphase mit einem Schalter.

Ein Ausführungsbeispiel wird nachfolgend anhand der Zeichnung näher erläutert. Es zeigen:

Fig. 1    Schaltungskomponenten eines Switched Capacitor Ver- stärker mit vergrößert dargestellt Komponenten eines darin enthaltenen 2-stufigen Verstärkers mit Fre- quenzkompensation,

Fig. 2    effektiv wirksame Schaltungskomponenten der Verstär- kerschaltungsanordnung aus Fig. 1 in einer ersten Taktphase,

Fig. 3    effektiv wirksame Schaltungskomponenten der Verstär- kerschaltungsanordnung aus Fig. 1 in einer zweiten Taktphase mit geschalteter Frequenz-Kompensation,

Fig. 4    zu dem Verstärker gemäß Fig. 1 einen Open Loop- Frequenzgang für die erste Taktphase als volle Linie und für die zweite Taktphase als Strich-Linie, einen Closed Loop-Frequenzgang für die erste Taktphase als Punkt-Linie und einen Closed Loop-Frequenzgang für die zweite Taktphase als Strich-Punkt-Linie,

Fig. 5    eine alternative Ausgestaltung von geschalteten Kom- ponenten eines 2-stufigen Verstärkers mit Frequenz-kompensation in einem Switched Capacitor Verstärker,

Fig. 6    einen 2-stufigen Verstärker mit Frequenzkompensation gemäß dem Stand der Technik und

Fig. 7    zu dem Verstärker gemäß Fig. 6 einen Open Loop- Frequenzgang als volle Linie, einen Closed Loop- Frequenzgang für die erste Taktphase als Punkt-Linie und einen Closed Loop-Frequenzgang für die zweite Taktphase als Strich-Punkt-Linie.

Fig. 1 veranschaulicht in der rechten Ausschnittsvergrößerung eine besonders bevorzugte Möglichkeit der Realisierung eines geeigneten Verstärkers.

Ein Schaltungseingang i, an welchem eine Eingangsspannung Vi anliegt, führt zu einem ersten Schalter S1 und einem parallel dazu geschalteten zweiten Schalter S2. Ansteuerbar zum Schließen sind diese beiden Schalter S1, S2 durch ein erstes Schaltsignal, welches in einer ersten Taktphase Φ1 angelegt wird. Zwischen den ersten Schalter S1 und einen Verstärker-Eingangsknoten n des Verstärkers V* ist in Reihe eine zweite schaltbare Kapazität Cs geschaltet. Außerdem ist zwischen den zweiten Schalter S2 und den Verstärker-Eingangsknoten n eine erste schaltbare Kapazität Cf geschaltet. Ein negativ gesetzter Eingang des Verstärkers V* ist zwischen den Verstärker-Eingangsknoten n und einen Schaltungsausgang bzw. Verstärker-Ausgangsknoten o geschaltet. An dem Verstärker-Ausgangsknoten o ergibt sich entsprechend eine Ausgangsspannung Vo. Ein positiv gesetzter Eingang des Verstärkers V ist an einen Masseanschluss bzw. an ein Bezugspotential GND geschaltet.

Außerdem ist der Verstärker-Eingangsknoten n über einen dritten Schalter S3 parallel zum Verstärker V an den Verstärker-Ausgangsknoten o schaltbar. Zum schließenden Schalten des dritten Schalters S3 ist an diesen ebenfalls das erste Schaltsignal Φ1 anlegbar. Außerdem ist an einen Knoten zwischen dem ersten Schalter S1 und der zweiten schaltbaren Kapazität Cs über einen fünften Schalter S5 eine Steuerspannung in Form beispielsweise einer Digital-/Analog-Wandler-Ausgangsspannung Vdac anlegbar. Zum schließenden Schalten des fünften Schalters S5 dient ein zweites Schaltsignal, welches in der zweiten Taktphase Φ2 angelegt wird. Über einen vierten Schalter S4, welcher ebenfalls mittels des zweiten Schaltsignals schließend angesteuert wird, ist ein Knoten zwischen dem zweiten Schalter S2 und der ersten schaltbaren Kapazität Cf mit dem Verstärker-Ausgangsknoten o zusammenschaltbar.

Außerdem weist die Anordnung eine Steuereinrichtung X auf, welche unter anderem zum Bereitstellen des ersten und des zweiten Schaltsignals in der ersten bzw. zweiten Taktphase Φ1, Φ2 ausgebildet ist. Die Ansteuerung erfolgt dabei in für sich bekannter Art und Weise. Die Funktionsweise entspricht im wesentlichen, wie auch der Aufbau, der Beschreibung zum Stand der Technik.

In Reihe geschaltet sind zwischen den Verstärker-Eingangsknoten n und den Verstärker-Ausgangsknoten o eine vorgeschaltete Verstärkerstufe V1 und eine Verstärkerstufe V2, welche eine Steilheit gm1 bzw. gm2 aufweisen. Zwischen den beiden Verstärkerstufen V1, V2 befindet sich ein Knoten, welcher nachfolgend als Kompensations-Eingangsknoten n2 bezeichnet wird. Zwischen den Masseanschluss bzw. das Bezugspotential GND und den Kompensations-Eingangsknoten n2 sind parallel zueinander eine erste Verstärker-Kapazität C1 und ein erster weiterer Widerstand Ro1 geschaltet. Außerdem ist zwischen den Masseanschluss bzw. das Bezugspotential GND und den Verstärker-Ausgangsknoten o eine Lastkapazität CL und ein zweiter weiterer Widerstand Ro2 parallel zueinander geschaltet.

Anstelle der in Fig. 6 skizzierten Gesamtkapazität zur Frequenzkompensation CC wird bei der bevorzugten Ausführungsform gemäß Fig. 1 eine Kapazität mit einem geringeren Kapazitätswert eingesetzt. Diese bildet somit eine erste Kapazität zur Frequenzkompensation CC1, welche in Reihe mit dem ersten Kompensationswiderstand RZ zwischen den Kompensations-Eingangsknoten n2 und den Verstärker-Ausgangsknoten o geschaltet ist. Parallel dazu ist zwischen den Kompensations-Eingangsknoten n2 und den Verstärker-Ausgangsknoten o in Reihe ein Kompensationsschalter SFC und eine zweite Kapazität zur Frequenzkompensation CC2 geschaltet. Vorzugsweise sind die Kapazitätswerte der ersten und der zweiten Kapazität zur Frequenzkompensation CC1, CC2 so gewählt, dass diese die gleiche Wirkung wie die Gesamtkapazität haben, wenn der Kompensationsschalter SFC geschlossen ist. Angesteuert wird der Kompensationsschalter SFC zum Schließen durch ein Kapazitäts-Schaltsignal clk, welches von der Steuereinrichtung X ebenfalls bereitgestellt wird. Das Kapazitäts-Schaltsignal clk ist vorzugsweise invers zu dem Steuersignal der zweiten Taktphase Φ2 gesteuert bzw. gleich dem Schaltsignal der ersten Taktphase Φ1.

Optional kann in Reihe mit dem Kompensationsschalter SFC und der zweiten Kapazität zur Frequenzkompensation CC2 ein noch weiterer Ohm'scher Widerstand geschaltet sein. Bevorzugt wird jedoch eine Ausgestaltung, bei welcher der Kompensationsschalter SFC einen geeigneten Widerstandswert aufweist.

Die aus Fig. 6 bekannte Kapazität CC zur Frequenzkompensation wird somit gemäß der bevorzugten Ausführungsform in Fig. 1 aufgeteilt in zwei Kapazitäten, eine erste und eine zweite geteilte Kapazität zur Frequenzkompensation CC1 bzw. CC2. Während der zweiten Taktphase Φ2 ist der Kompensationsschalter SFC geöffnet und nur die erste geteilte Kapazität zur Frequenzkompensation CC1 ist für die Frequenzkompensation wirksam. Diese ist für ein optimales Einschwingverhalten des Systems während der zweiten Taktphase Φ2 geeignet einzustellen, insbesondere zu optimieren und ist damit eine Funktion des Rückkopplungsfaktors β(Φ2) und der Lastkapazität CL(Φ2) während der zweiten Taktphase Φ2.

Während der ersten Taktphase Φ1 ist der Rückkopplungsfaktor β (Φ1) größer als der Rückkopplungsfaktor β (Φ2) während der zweiten Taktphase Φ2, d.h. es gilt β(Φ1) > β(Φ2).

Im Falle der Anwendung bei einem Pipeline-Analog-Digital-Wandler ist dieser um den Faktor 2 höher. Für gleiches Einschwingverhalten des Systems während der ersten Taktphase Φ1 und der zweiten Taktphase Φ2 bedeutet das, dass die GesamtKapazität CC zur Frequenzkompensation zu verdoppeln ist. Das erfolgt, indem der Kompensationsschalter SFC während der ersten Taktphase Φ1 geschlossen wird. Dadurch wird der ersten schaltbaren Kapazität CF die zweite schaltbare Kapazität CS der übergeordneten umgebenden Schaltungskomponenten parallel geschaltet und das Verstärkungs-Bandbreiten-Produkt verringert.

Der Wert der ersten Verstärker-Kapazität C1 ist unabhängig vom Wert der ersten schaltbaren Kapazität CF einzustellen, insbesondere zu optimieren, um einen Einfluss unterschiedlicher Lastkapazitäten etc. zu berücksichtigen, und ist in der Praxis nicht unbedingt gleich dem Wert der ersten schaltbaren Kapazität CF der den Verstärker V umgebenden Schaltungskomponenten. Damit wird ein regelungstechnisch stabiles System sowohl in der ersten Taktphase Φ1 als auch in der zweiten Taktphase Φ2 erzielt ohne die Stromaufnahme zu erhöhen.

Für Verstärkerstrukturen mit mehrfacher Frequenzkompensation, so genannter nested compensation, kann vorzugsweise jede der geteilten Kapazitäten zur Frequenzkompensation CC1, CC2 zwischen den beiden Taktphasen Φ1 und Φ2 umgeschaltet werden.

Eine weitere Verbesserung der Frequenzkompensation kann unter Verwendung einer zusätzlichen Nullstelle in der Übertragungsfunktion des Frequenzkompensationsnetzwerkes erfolgen. Dazu wird der Kompensationskapazität aus der ersten und der zweiten geteilten Kapazität zur Frequenzkompensation CC1, CC2 jeweils ein Widerstand als Kompensationswiderstand RZ in Serie geschaltet. Insbesondere kann eine weitere Verbesserung der Frequenzkompensation durch die Verwendung von verschiedenen solcher Widerstands-Kapazitäts-Serienschaltungen in den beiden Taktphasen Φ1 und Φ2 erfolgen.

Vorzugsweise kann dazu der Widerstand des geschlossen Kompensationsschalters SFC selbst komplett oder teilweise als Serienwiderstand bzw. als Kompensationswiderstand in Reihe geschaltet zur zweiten geteilten Kapazität zur Frequenzkompensation CC2 verwendet werden. Wird der Schalter SFC selbst als Kompensationswiderstand verwendet, ist es vorteilhaft den ersten Kompensationswiderstand RZ in dem Kompensationszweig, welcher nur während der zweiten Taktphase $\Phi 2$ aktiv ist, ebenfalls durch einen Schalter zu ersetzen. Damit wird ein besonders gutes Anpassen (engl. Matching) zwischen den beiden Taktphasen $\Phi 1$, $\Phi 2$ erreicht.

Eine solche Anordnung ist sowohl für sogenannte Single-Ended als auch für voll differentielle Verstärkerschaltungen anwendbar.

In Fig. 1 sind allgemein Steilheiten gm1 bzw. gm2 beschrieben. Damit die Anordnung in Fig. 1 arbeitet, ist die Verstärkung der zweiten Stufe, nämlich das Produkt aus den werten der Steilheit gm2 und des zweiten weiteren Widerstands Ro2 selbst natürlich negativ. Also ist die Steilheit gm2 der Verstärkerstufe V2 negativ. Mathematisch ist das korrekt, da die Steilheit gm2 nicht auf positive Werte begrenzt wird.

Fig. 4 zeigt anschaulich den Frequenzgang der Leerlaufverstärkung (engl. Open Loop) während der ersten Taktphase $\Phi_1$ als volle Linie und den daraus resultierenden Frequenzgang der rückgekoppelten Schaltung für den Rückkopplungsfaktor $\beta = 1$ während der ersten Taktphase $\Phi_1$, sowie den Frequenzgang der Open Loop- bzw. Leerlaufverstärkung während der zweiten Taktphase $\Phi_2$ als Punkt-Linie und den daraus resultierenden Frequenzgang der rückgekoppelten Schaltung für den Rückkopplungsfaktor $\beta = 1/2$ während der zweiten Taktphase $\Phi_2$. Durch eine Erhöhung des Verstärkungs-Bandbreiten-Produktes während der zweiten Taktphase $\Phi_2$ wird für die gegengekoppelte Schaltung während der zweiten Taktphase $\Phi_2$ für den für den Rückkopplungsfaktor $\beta = 1/2$ nahezu die selbe Bandbreite erreicht, wie während der ersten Taktphase $\Phi_1$.

Ein Dummy-Schalter in Serie mit einer nicht geschalteten zweiten Kapazität zur Frequenzkompensation CC2 als "Nulling-Resistor" ist vorteilhaft, um eine Verbesserung des Matching mit der anderen, ersten geschalteten Kapazität CC1 zu erreichen.

Fig. 5 zeigt eine beispielhaft modifizierte Ausführungsform zur Ausbildung eines sogenannten nested cascode miller OpAmp, wobei nachfolgend im wesentlichen nur unterschiedliche Merkmale zur Ausgestaltung gemäß Fig. 1 beschrieben werden. Die erste Kapazität zur Frequenzkompensation CC1 und die zumindest eine zweite Kapazität oder der zur Frequenzkompensation CC2 oder der Kompensationsschalter SFC sind mit deren einem Ende wieder an einen Eingang n3 der Verstärkerstufe V2 geschaltet. Zusätzlich ist an einen Ausgang n4 der dazu vorgeschalteten Verstärkerstufe V1 und zu der Verstärkerstufe V2 parallel eine dritte Kapazität zur Frequenzkompensation CC3 geschaltet. Eine vierte Kapazität zur Frequenzkompensation CC4 ist mittels eines weiteren Kapazitäts-Schaltsignals clk2 und/oder eines weiteren Kompensationsschalters SFC2 zu- oder wegschaltbar parallel zu dieser dritten Kapazität zur Frequenzkompensation CC3 und an den Ausgang n4 geschaltet.

Im Wesentlichen sind somit die dritte und die vierte Kapazität parallel zu der ersten und der zweiten Kapazität geschaltet. Zwischen den Eingang n3 der Verstärkerstufe V2 und den Ausgang n4 der vorgeschalteten Verstärkerstufe V1 ist eine weitere Stufe geschaltet, welche als Kaskode für die erste Verstärkerstufe V1 bzw. deren Steilheit gm1 arbeitet. Im Ausführungsbeispiel Fig.5 ist diese weitere, als Kaskode arbeitende Stufe beispielhaft mit einen MOSFET ausgeführt. Von dem MOSFET ist dessen Source-Anschluss am Knoten bzw. am Ausgang n4 der vorgeschalteten Verstärkerstufe V1 angeschlossen, dessen Drain-Anschluss am Konten bzw. Eingang n3 der Verstärkerstufe V2 angeschlossen und dessen Gate-Anschluss an einem weiteren Bezugspotential Vbias angeschlossen.

Dargestellt sind beispielhaft Verstärker mit einer bzw. zwei dazu parallel geschalteten schaltbaren Kapazitäten. Bei einem Miller-kompensierten Verstärker gemäß Fig. 1 ist es im einfachsten Fall nur eine Kapazität. Nach diesem Grundprinzip umsetzbar sind aber auch weitere Ausgestaltungen, bei denen noch mehr oder auch alle an einer Frequenzkompensation beteiligten Kapazitäten schaltbar ausgelegt sind. Ob tatsächlich alle diese Kapazitäten geschaltet werden oder nur eine, was für die meisten Anwendungen ausreichend ist, ist jedoch egal.

In Fig. 1 ist nur eine Kapazität beschieben. Wird ein volldifferentieller Verstärker verwendet, sind es entsprechend übertragen auch in einer einfachen Anordnung praktisch zwei Kapazitäten, welche schaltbar sind.

Bezugszeichenliste:

A,A0 Verstärkung des Verstärkers
Aerr Verstärkungsfehler
C1 erste Verstärker-Kapazität
CC Kapazität bzw. Gesamtkapazität zur Frequenzkompensation
CC1 erste Kapazität zur Frequenzkompensation
CC2 zweite Kapazität zur Frequenzkompensation
CC3 dritte Kapazität zur Frequenzkompensation

CC4 vierte Kapazität zur Frequenzkompensation
Cf erste schaltbare Kapazität
Cs zweite schaltbare Kapazität
CL Lastkapazität
clk Kapazitäts-Schaltsignal
clk2 weiteres Kapazitäts-Schaltsignal
fT Transitfrequenz
gm1, gm2 Steilheiten der Verstärkerstufen
Gain Verstärkung der Gesamt-Verstärkerschaltung
GBW Verstärkungs-Bandbreiten-Produkt des Verstärkers
GND Masseanschluss bzw. Bezugspotential
i Schaltungseingang
IC Verstärkerschaltung mit geschalteter Kapazität
n Verstärker-Eingangsknoten
n2 Kompensations-Eingangsknoten
n3 Eingang von Verstärkerstufe
n4 Ausgang vorgeschalteter Verstärkerstufe
o Schaltungsausgang bzw. Verstärker-Ausgangsknoten
Ro1 erster weiterer Widerstand
Ro2 zweiter weiterer Widerstand
RZ erster Kompensationswiderstand
S1 erster Schalter
S2 zweiter Schalter
S3 dritter Schalter
S4 vierter Schalter
S5 fünfter Schalter
SFC Kompensationsschalter
SFC2 weiterer Kompensationsschalter
V, V* Verstärker
V1 vorgeschaltete Verstärkerstufe
V2 Verstärkerstufe
Vbias weiteres Bezugspotential
Vcm Referenzspannung
Vdac Digital/Analog-Wandler-Ausgangsspannung
Vi Eingangsspannung
Vo Ausgangsspannung
Voff Offsetspannung
X Steuereinrichtung
β Rückkopplungsfaktor
Φ1 erste Taktphase mit erstem Schaltsignal
Φ2 zweite Taktphase mit zweitem Schaltsignal

**Patentansprüche**

1. Verstärker (V) für eine Verstärkerschaltung (IC) mit geschalteter Kapazität (Cs, Cf), wobei zu einer Verstärkerstufe (V2) parallel eine erste Kapazität zur Frequenzkompensation (CC1) geschaltet ist,
**dadurch gekennzeichnet, dass**
zumindest eine zweite Kapazität zur Frequenzkompensation (CC2) mittels eines Kapazitäts-Schaltsignals (clk) und eines Kompensationsschalters (SFC) zu- oder wegschaltbar parallel zu dieser ersten Kapazität zur Frequenzkompensation (CC1) geschaltet ist, bei dem ein Kompensationswiderstand (RZ) in Reihe mit der ersten Kapazität zur Frequenzkompensation (CC1) geschaltet ist, und bei dem der Kompensationswiderstand (RZ) durch einen weiteren und geschlossenen Schalter mit Parametern des Kompensationsschalters (SFC) ausgebildet ist, wobei der weitere Kompensationsschalter nicht geschaltet wird oder nicht schaltbar ist.

2. Verstärker (V) nach Anspruch 1, bei dem der Kompensationsschalter (SFC) einen Schalterwiderstand aufweist, welcher zugeschaltet eine Reihenschaltung eines insbesondere Ohm'schen Widerstands zu der zweiten Kapazität zur Frequenzkompensation (CC2) bewirkt.

**3.** Verfahren zum Steuern eines Verstärkers (V),
wobei der Verstärker (V) für eine Verstärkerschaltung (IC) mit geschalteter Kapazität (Cs, Cf) eine Verstärkerstufe (V2) umfasst, zu der parallel eine erste Kapazität zur Frequenzkompensation (CC1) geschaltet ist,
**dadurch gekennzeichnet, dass**
zumindest eine zweite Kapazität zur Frequenzkompensation (CC2) mittels eines Kapazitäts-Schaltsignals (clk) und eines Kompensationsschalters (SFC) zu- oder wegschaltbar parallel zu dieser ersten Kapazität zur Frequenzkompensation (CC1) geschaltet ist, bei dem ein Kompensationswiderstand (RZ) in Reihe mit der ersten Kapazität zur Frequenzkompensation (CC1) geschaltet ist, und bei dem der Kompensationswiderstand (RZ) durch einen weiteren und geschlossenen Schalter mit Parametern des Kompensationsschalters (SFC) ausgebildet ist, wobei der weitere Kompensationsschalter nicht geschaltet wird oder nicht schaltbar ist, wobei das Kapazitäts-Schaltsignal (clk) angelegt wird, mit dem die zumindest eine zweite Kapazität zur Frequenzkompensation (CC2) parallel zu der ersten Kapazität zur Frequenzkompensation (CC1) zu- oder weggeschaltet wird.

**Claims**

**1.** An amplifier (V) for an amplifier circuit (IC) having a switched capacitor (Cs, Cf), wherein a first capacitor for frequency compensation (CC1) is connected in parallel to an amplifier stage (V2),
**characterized in that**
at least a second capacitor for frequency compensation (CC2) is connected in parallel to the first capacitor for frequency compensation (CC1) in a manner that it can be activated or deactivated via a capacitor switching signal (clk) and a compensation switch (SFC), wherein a compensation resistor (RZ) is connected in series with the first capacitor for frequency compensation (CC1), and wherein the compensation resistor (RZ) is formed by an additional and closed switch using parameters of the compensation switch (SFC), the additional compensation switch not being switched or not being switchable.

**2.** The amplifier (V) according to claim 1, wherein the compensation switch (SFC) comprises a switching resistor, which, when it is switched, creates a series circuit of an ohmic resistor in particular to the second capacitor for frequency compensation (CC2).

**3.** A method for controlling an amplifier (V), the amplifier (V) comprising an amplifier stage (V2) for an amplifier circuit (IC) having a switched capacitor (Cs, Cf), wherein a first capacitor for frequency compensation (CC1) is connected in parallel to said amplifier stage (V2),
**characterized in that**
at least a second capacitor for frequency compensation (CC2) is connected in parallel to the first capacitor for frequency compensation (CC1) in a manner that it can be connected or disconnected via a capacitor switching signal (clk) and a compensation switch (SFC), wherein a compensation resistor (RZ) is connected in series with the first capacitor for frequency compensation (CC1), and wherein the compensation resistor (RZ) is formed by an additional and closed switch using parameters of the compensation switch (SFC), the additional compensation switch not being switched or not being switchable, wherein the capacitor switching signal (clk) is connected by means of which the at least one second capacitor for frequency compensation (CC2) is activated or deactivated parallel to the first capacitor for frequency compensation (CC1).

**Revendications**

**1.** Amplificateur (V) destiné à un circuit amplificateur (IC) comportant un condensateur commuté (Cs, Cf) dans lequel un premier condensateur permettant une compensation de fréquence (CC1) est branché en parallèle à un étage d'amplificateur (V2),
**caractérisé en ce que**
au moins un deuxième condensateur permettant une compensation de fréquence (CC2) est branché en parallèle au premier condensateur permettant une compensation de fréquence (CC1) de manière à pouvoir être activé ou désactivé par le biais d'un signal de commutation de condensateur (clk) et d'un interrupteur de compensation (SFC), dans lequel une résistance de compensation (RZ) est branchée en série avec le premier condensateur pour une compensation de fréquence (CC1) et dans lequel la résistance de compensation (RZ) est formée par un interrupteur supplémentaire et fermé à l'aide de paramètres de l'interrupteur de compensation (SFC), l'interrupteur supplémentaire de compensation n'étant pas commuté ou n'étant pas commutable.

2. Amplificateur (V) selon la revendication 1, dans lequel l'interrupteur de compensation (SFC) comprend une résistance de commutation qui, quand elle est commutée, crée un circuit série d'une résistance ohmique, en particulier vers le deuxième condensateur permettant une compensation de fréquence (CC2).

3. Procédé de commande d'un amplificateur (V), l'amplificateur (V) comprenant un étage d'amplificateur (V2) pour circuit amplificateur (IC) comportant un condensateur (Cs, Cf), dans lequel un premier condensateur pour une compensation de fréquence (CC1) est branché en parallèle avec ledit étage d'amplificateur (V2),
**caractérisé en ce que**
au moins un deuxième condensateur permettant une compensation de fréquence (CC2) est branché en parallèle avec le premier condensateur permettant une compensation de fréquence (CC1) d'une manière telle qu'il peut être branché ou débranché par le biais d'un signal de commutation de condensateur (clk) et d'un interrupteur de compensation (SFC), dans lequel une résistance de compensation (RZ) est branchée en série avec le premier condensateur pour une compensation de fréquence (CC1) et dans lequel la résistance de compensation (RZ) est formée par un interrupteur supplémentaire et fermé à l'aide de paramètres de l'interrupteur de compensation (SFC), l'interrupteur supplémentaire de compensation n'étant pas commuté ou n'étant pas commutable, dans lequel le signal de commutation du condensateur (clk) est branché par un moyen tel que l'au moins un deuxième condensateur permettant une compensation de fréquence (CC2) est activé ou désactivé en parallèle du premier condensateur permettant une compensation de fréquence (CC1).

Fig. 1

Fig. 2

Fig. 3

Fig. 5

Fig. 6 (Stand der Technik)

$f_{-3dB}(\Phi_2)\sim 0.5 \times f_{-3dB}(\Phi_1)$

$f_T = f_{-3dB}(\Phi_1)$

Fig. 7 (Stand der Technik)

$f_{-3dB}(\Phi_2)f_T \sim f_{-3dB}(\Phi_1)$

$f_T = f_{-3dB}(\Phi_1)$

Fig. 4

**IN DER BESCHREIBUNG AUFGEFÜHRTE DOKUMENTE**

**In der Beschreibung aufgeführte Patentdokumente**

- US 2002153946 A1

**In der Beschreibung aufgeführte Nicht-Patentliteratur**

- **P.E. ALLAN ; D.R. HOLBERG.** CMOS Analog Circuit Design. Oxford University Press, 1987, 374ff